(19)

**Europäisches Patentamt**

**European Patent Office**

**Office européen des brevets**

(11) **EP 4 628 906 A1**

(12) **EUROPEAN PATENT APPLICATION**

(43) Date of publication:
**08.10.2025 Bulletin 2025/41**

(21) Application number: **25164225.2**

(22) Date of filing: **17.03.2025**

(51) International Patent Classification (IPC):
*G01R 27/08* (2006.01)     *G01R 27/16* (2006.01)
*G01R 31/58* (2020.01)     *G01R 31/66* (2020.01)

(52) Cooperative Patent Classification (CPC):
**G01R 27/08; G01R 27/16; G01R 31/58;
G01R 31/66**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.03.2024 US 202463565982 P**

(71) Applicants:
• **Autronica Buyer Norway AS
7047 Trondheim (NO)**

• **Carrier Corporation
Palm Beach Gardens, FL 33418 (US)**

(72) Inventors:
• **VANNEBO, Per Johan
Bromstadveien (NO)**
• **OLSEN, Geir Tore
Bromstadveien (NO)**

(74) Representative: **Dehns
10 Old Bailey
London EC4M 7NG (GB)**

(54) **DEVICE AND METHOD FOR DIAGNOSING FIELD EQUIPMENT LOOP CABLE**

(57)     Described herein is a device for diagnosing a field equipment loop cable connected to a plurality of loop units. The device comprises one or more loop driver configured to be connected to one or more ends of the cable. The one or more loop driver comprises current limiter, electrical sensors, and a controller. The controller is configured to selectively activate one of the loop units while electrically isolating the remaining loop units, actuate the current limiter to supply and regulate flow of the current through the activated loop unit to a predetermined level, monitor, using the electrical sensors, the current flowing through cable via the activated loop unit and the voltage at the positive terminal and the negative terminal of the cable, and determine resistance between the loop driver and the activated loop unit based on the monitored voltage and current.

FIG. 1A

## EP 4 628 906 A1

**Description**

## BACKGROUND

This invention relates to a field of diagnostic systems and, more particularly, to a device and a method for diagnosing field equipment loop cables.

## SUMMARY

Described herein is a device for diagnosing field equipment loop cables connected to a plurality of loop units. The device comprises one or more loop driver configured to be connected between a positive terminal and a negative terminal at one or more ends of the cable. The one or more loop driver comprises one or more current limiters to supply and regulate the flow of current through the cable and the respective loop units via one or more ends of the cable, and one or more electrical sensors to monitor the current flowing through the cable and monitor the voltage at the corresponding positive terminal and the negative terminal of the cable. The device further comprises a controller connected to the one or more loop driver and each of the loop units. The controller comprises a processor coupled to a memory storing instructions executable by the controller, which causes the controller to selectively activate at least one of the loop units among the plurality of loop units while electrically isolating the remaining loop units among the plurality of loop units. The controller further actuates the one or more current limiters to supply and regulate the flow of the current through the activated loop unit to a predetermined level, further monitor, using the one or more electrical sensors, the current flowing through cable via the activated loop unit and the voltage at the positive terminal and the negative terminal of the cable, and determine resistance between the one or more loop driver and the activated loop unit based on the monitored voltage, and the monitored current.

In one or more embodiments, the controller is configured to determine the resistance of a segment between the one or more loop driver and the activated loop unit of the cable based on the monitored voltage, the monitored current, and an internal resistance associated with the activated loop unit, wherein the activation of the loop unit electrically connects the internal resistance to the cable.

In one or more embodiments, the controller is configured to subsequently activate one of the loop units while electrically isolating the remaining loop units and correspondingly determining the resistance of the cable between the one or more loop driver and each of the subsequently activated loop units and determine the resistance of each of the segments of the cable, and one or more branches associated with the cable based on the determined resistance of the segment between the one or more loop driver and each of the subsequently activated loop units.

In one or more embodiments, the controller is connected to one or more first switches associated with each of the loop units, wherein the controller is configured to turn ON the first switch associated with the loop unit to activate the corresponding loop unit and turn OFF the first switch associated with the loop unit to electrically isolate the corresponding loop unit from the cable and the one or more loop driver.

In one or more embodiments, one or more electrical sensors comprise a current sensor to monitor the current flowing through the cable via the activated loop unit, a first voltage sensor at the positive terminal of the cable to monitor the voltage at the positive terminal of the cable, and a second voltage sensor at the negative terminal of the cable to monitor the voltage at the negative terminal of the cable.

In one or more embodiments, the one or more loop driver comprises a shunt resistor of a predefined resistance connected, via a second switch, between a positive wire and a negative wire connecting the one or more loop driver to the positive terminal and the negative terminal of the cable respectively, at each of the ends of the cable.

In one or more embodiments, the controller is configured to actuate the second switch to electrically connect the shunt resistor in parallel to the cable and the corresponding loop unit, which facilitates the discharge of capacitance or residual current of the cable.

In one or more embodiments, the one or more loop driver is configured to detect, using the electrical sensors, a surge in current within the cable upon the connection of the shunt resistance to the cable and actuate the one or more current limiters to regulate the flow of the current through the loop cable to the predetermined level upon detection of the current surge.

In one or more embodiments, the controller is configured to de-actuate the second switch to isolate the shunt resistor from the one or more loop driver and the cable, wherein the shunt resistor is isolated during the resistance measurement or the diagnosis of the cable.

In one or more embodiments, the one or more loop driver comprises one or more third switches configured in a positive wire and a negative wire connecting the one or more loop driver to the positive terminal and the negative terminal of the cable, respectively, at each of the ends of the cable, wherein the controller is connected to each of the third switches and configured to turn ON the third switch to electrically connect the one or more loop driver to the cable, and turn OFF the third switch to electrically isolate the one or more loop driver from the cable and the loop units.

In one or more embodiments, the plurality of loop units comprises one or more of a smoke detector, a motion

2

detector, an occupancy detector, an alarm, a beacon module, a control panel, a loop interface module, and a power supply unit.

In one or more embodiments, the controller is further configured to transmit the determined resistance to a remote monitoring system that is communicating with the one or more loop driver.

In one or more embodiments, the controller is further configured to determine minimum voltages across each of the segments of the cable and across each of the loop units in an alarm state based on the determined resistance of one or more segments.

In one or more embodiments, the controller is configured to map the determined resistance and the determined minimum voltage of one or more segments to predefined locations on the cable, which enables one or more users or the controller to identify the determined resistance of the one or more segments and/or weak or unsafe segments in the cable.

Also described herein is a method for diagnosing a field equipment loop cable connected to a plurality of loop units. The method comprises connecting one or more loop driver between a positive terminal and a negative terminal at one or more ends of the cable. The method comprises selectively activating, by a controller connected to the one or more loop driver and each of the loop units, at least one of the loop units among the plurality of loop units while electrically isolating the remaining loop units among the plurality of loop units. The method further comprises actuating, by the controller, one or more current limiters to supply and regulate current flow through the loop cable to a predetermined level. Further, the method comprises monitoring, by the controller, the current flowing through the cable by the activated loop unit and the voltage at the positive terminal and the negative terminal of the cable, using one or more electrical sensors and determining, by the controller, the resistance between the one or more loop driver and the activated loop unit based on the monitored voltage and the monitored current.

In one or more embodiments, the method further comprises determining, by the controller, the resistance of a segment between the one or more loop driver and the activated loop unit of the cable based on the monitored voltage, the monitored current, and an internal resistance associated with the activated loop unit, wherein the activation of the loop unit electrically connects the internal resistance to the cable.

In one or more embodiments, the method further comprises subsequently activating, by the controller, one of the loop units while electrically isolating the remaining loop units and correspondingly determining the resistance of the cable between the one or more loop driver and each of the subsequently activated loop unit and determining by the controller resistance of each of the segments of the cable and one or more branches associated with the cable based on the determined resistance of the segment between the one or more loop driver and each of the subsequently activated loop units.

In one or more embodiments, the method further comprises determining, by the controller, minimum voltages across each of the segments of the cable and/or across each of the loop units in an alarm state based on the determined resistance of the one or more segments.

In one or more embodiments, the method further comprises mapping, by the controller, the determined resistance, and the determined minimum voltage of the one or more segments to predefined locations on the cable, which enables one or more users or the controller to identify the determined resistance of the one or more segments and/or weak or unsafe segments in the cable.

The preceding summary is illustrative only and is not intended to be in any way limiting. In addition to the illustrative aspects, embodiments, and features described above, further aspects, embodiments, features, and techniques of the subject disclosure will become more apparent from the following description in conjunction with the drawings.

**BRIEF DESCRIPTION OF THE DRAWINGS**

The accompanying drawings are included to provide a further understanding of the subject disclosure and are incorporated in and constitute a part of this specification. The drawings illustrate exemplary embodiments of the subject disclosure and, together with the description, serve to explain the principles of the subject disclosure.

In the drawings, similar components and/or features may have the same reference label. Further, various components of the same type may be distinguished by following the reference label with a second label that distinguishes among the similar components. If only the first reference label is used in the specification, the description is applicable to any one of the similar components having the same first reference label, irrespective of the second reference label.

FIG. 1A illustrates an exemplary representation of a device for diagnosing a field equipment loop cable connected to a plurality of loop units in accordance with one or more embodiments of the subject disclosure.

FIG. 1B illustrates a block diagram of the device of FIG. 1A in accordance with one or more embodiments of the subject disclosure.

FIG. 1C illustrates another exemplary representation of the device of FIG. 1A wherein field equipment loop cable is connected to a dual safety system in accordance with one or more embodiments of the subject disclosure.

FIG. 2A illustrates an exemplary representation of a segment of the cable with two loop units to describe the working of the invention in accordance with one or more embodiments of the subject disclosure.

FIG. 2B illustrates an exemplary representation of the segment of FIG. 2A, in which a first loop unit is activated while the second loop unit is electrically isolated in accordance with one or more embodiments of the subject disclosure.

FIG. 2C illustrates an exemplary representation of the segment of FIG. 2A, in which a second loop unit is activated while the first loop unit is electrically isolated in accordance with one or more embodiments of the subject disclosure.

FIG. 3 illustrates a schematic flow diagram for a method for diagnosing a field equipment loop cable connected to a plurality of loop units, according to an embodiment of the present disclosure.

DETAILED DESCRIPTION

The following is a detailed description of embodiments of the disclosure depicted in the accompanying drawings. The embodiments are in such detail as to clearly communicate the disclosure. However, the amount of detail offered is not intended to limit the anticipated variations of embodiments; on the contrary, the intention is to cover all modifications, equivalents, and alternatives falling within the spirit and scope of the subject disclosure as defined by the appended claims.

Various terms are used herein. To the extent a term used in a claim is not defined below, it should be given the broadest definition persons in the pertinent art have given that term as reflected in printed publications and issued patents at the time of filing.

In the specification, reference may be made to the spatial relationships between various components and to the spatial orientation of various aspects of components, as the devices are depicted in the attached drawings. However, as will be recognized by those skilled in the art after a complete reading of the subject disclosure, the components of this invention. Described herein may be positioned in any desired orientation. Thus, the use of terms such as "above," "below," "upper," "lower," "first," "second," or other like terms to describe a spatial relationship between various components or to describe the spatial orientation of aspects of such components should be understood to describe a relative relationship between the components or a spatial orientation of aspects of such components.

Evaluating cable and connector resistance presents a significant challenge in various systems employing interconnected units through field cables to a central control or monitoring panel. The dependable operation of such systems relies on maintaining optimal resistance levels, especially during critical operational phases where increased current consumption occurs. Elevated resistance within the cables and connectors can result in voltage drops, leading to device malfunctions and compromised system reliability. Existing methodologies for resistance measurement of field equipment cable typically focus on assessing the overall loop resistance, needing more capability to identify resistance variations within individual segments or branching pathways associated with the cable.

This invention addresses the aforementioned limitations by providing a diagnostic device and method to accurately measure the resistance of each cable segment and connector within a field equipment loop connected to multiple units. This approach allows for precise determination of resistance within branching segments and facilitates the identification of weak points along the electrical pathway.

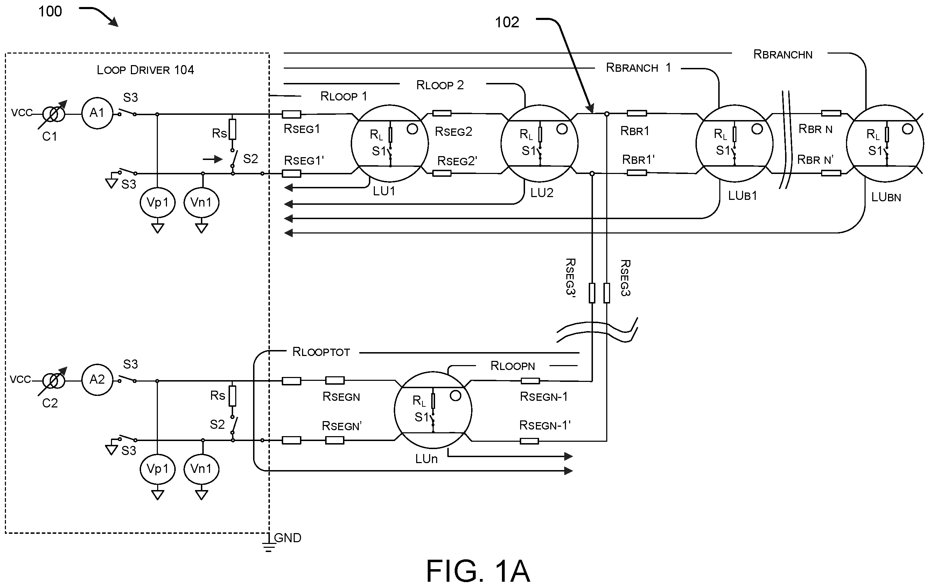

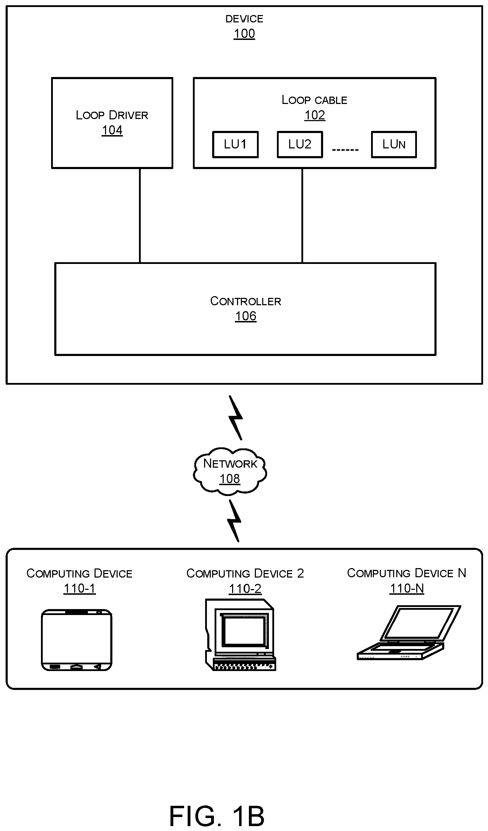

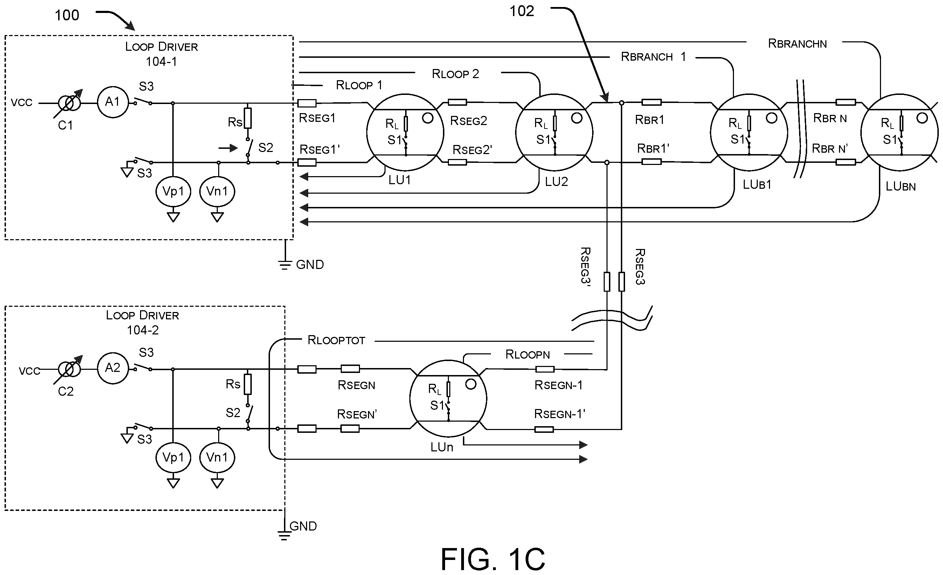

Referring to FIGs. 1A to FIG. 1C, a device 100 for diagnosing a field equipment loop cable (interchangeably referred to as cable or loop cable 102, herein) connected to a plurality of loop units (LU1, LU2.... Lun, $Lu_{B1}$...$LU_{BN}$) (collectively referred to as loop units LU and individually referred to as loop unit LU, herein) is disclosed. In a practical scenario, as depicted in FIG. 1, the plurality of loop units LU1, LU2.... LUn can be connected to loop cable 102, and further, the loop cable 102 can include or form multiple segments (Rseg1...Rsegn) and multiple branches (Rbr1....Rbrn) between the corresponding loop units. Further, it is to be appreciated that while the exemplary FIGs illustrates with one branch with several segments in practice, it is possible to have multiple branches with multiple segments.

In one or more embodiments, each of the loop units LU1, LU2.... LUn, and branches $Lu_{B1}$...$LU_{BN}$ may serve as a connection hub for diverse field equipment devices utilized in an area of interest (AOI) such as a but not limited to building infrastructures. These devices can encompass but are not restricted to smoke detectors, motion detectors, occupancy detectors, alarms, beacon modules, control panels, loop interface modules, input and or output modules, flame detectors, heat detectors, carbon monoxide detectors, gas detectors and power supply units. Moreover, each loop unit LU can possess the capability to accommodate a broad spectrum of equipment tailored to distinct functionalities and applications within a building environment. Furthermore, within each loop unit LU, there may exist one or more switches (referred to as first switches S1, herein). The switch S1 within each loop unit LU1, LU2.... LUn, and each branch $Lu_{B1}$...$LU_{BN}$ can enable the activation of the respective loop unit and branches to electrically isolate the associated loop unit and branch from the interconnected loop cable 102 and one or more loop driver 104.

Further, it is to be appreciated that while the exemplary description illustrates with respect to a fire alarm system where the plurality of loop units are connected via the loop cable to via the one or more loop driver to a fire panel (not depicted in the figures), the device's diagnostic capabilities extend beyond this specific application. In practice, the device 100 can be utilized to diagnose the loop cable of one or more electrical systems across various field equipment setups beyond fire alarm systems.

In one or more embodiments, the device 100 for diagnosing the field equipment loop cable can include a single loop driver 104 (as shown in FIG. 1A) or multiple loop drivers 104-1 and 104-2 (as shown in FIG.1C) (collectively referred to as loop driver 104), which can be a multifunctional component designed to interface with the loop cable 102. Further, the loop driver 104 can be designed to be integrated into existing electrical systems by connecting it between the positive and negative terminals at one or more ends of the loop cable 102. For instance, a positive wire and a negative wire can facilitate the connection of the loop driver 104 to the positive and negative terminals of the cable, respectively, at each end of the cable. This configuration ensures smooth integration of the device 100 into the electrical system, enabling efficient operation and diagnostic capabilities across various setups.

In one or more embodiments, the loop driver 104 can include a current limiters, such as C1 and C2, as depicted in FIG. 1A and FIG. 1C, to supply and regulate the current flow within the loop cable 102 and across the connected loop units LU1, LU2.... LUn. Additionally, the loop driver 104 may integrate electrical sensors to monitor both the current traversing the cable and the voltage levels at the respective positive and negative terminals. In one or more embodiments, the loop driver 104 can include a current sensor A1 to monitor the current flowing through cable 102 via the activated loop unit, a first voltage sensor Vp at the positive terminal of the cable 102 to monitor voltage at the positive terminal of the cable 102, and a second voltage sensor Vn at the negative terminal of the cable to monitor voltage at the negative terminal of the cable 102. In an example, the current limiters can be either adjustable or fixed. For instance, the current limiter could be a variable voltage source in conjunction with a fixed resistor, or alternatively, it could be a fixed voltage source coupled with variable resistance. Further, it is to be appreciated that while the exemplary description illustrates multiple current limiters and current sensors as shown in FIG. 1A, it is possible to use a common current limiter and current sensor connected to both S3's.

Furthermore, a shunt resistor Rs, as depicted in FIG.1A, of predetermined low resistance (for example say of 5 ohm, but not limited to the like) may be connected via a second switch S2, between the positive and negative wires connecting the loop driver 104 to the cable 102. Moreover, one or more third switches, S3, can be configured within the positive and negative wire connections, allowing for the selective electrical connection or isolation of the loop driver 104 from both the cable 102and the loop units LU1, LU2.... LUn at each cable termination point. This design configuration enhances the operational capabilities and monitoring functionalities of the loop driver 104, ensuring precise control and oversight of current dynamics within the loop cable 102.

In one or more embodiments, device 100 can further include a controller 106 that can be connected to the loop driver 104 and each of the loop units LU1, LU2.... LUn. In one or more embodiments, the controller 106 can be a digital control circuitry such as but not limited to a microcontroller that comprises a processor coupled to a memory storing instructions executable by the processor, which can cause the controller 106 to operate the loop driver 104 and/or individually control switching/actuation of each of the components within the loop driver 104 and the loop units LU1, LU2.... LUn. However, in other embodiments, the controller 106 can also be an analog control circuitry comprising one or more electrical devices, solid-state electronic devices, and/or power electronic devices available in the art, which can cause the controller to operate the loop driver 104 and/or individually control switching/actuation of each of the components within the loop driver 104 and the loop units LU1, LU2.... LUn.

Further, in one or more embodiments, the controller 106 can be the part of the loop driver 104. However, in some embodiments, the controller 106 can also be part of a control system associated with the alarm system in which the cable is employed.

In one or more embodiments, the processor of controller 106 can be a digital signal processor (e.g., a microprocessor, a microcontroller, or a fixed-logic processor, etc.) configured to execute instructions or logic. The processor may include a general-purpose processor, a special-purpose processor (where software instructions are incorporated into the processor), a state machine, an application-specific integrated circuit (ASIC), a programmable gate array (PGA) including a field PGA, an individual component, a distributed group of processors, and the like.

In one or more embodiments, the controller 106 can serve as a central component responsible for managing and coordinating communication within the device 100. The controller 106 can facilitate the exchange of data and commands between various elements, such as loop driver 104 and loop unit 102. The controller 106 can establish connections with the loop driver 104 as well as individual loop unit LU1, LU2.... LUn. These connections can enable the controller 106 to transmit instructions, receive feedback, and overall control the operation of the loop units LU1, LU2.... LUn through the loop driver 104, or the controller 106 may control the loop units LU1, LU2.... LUn and the loop driver 104 individually. However, in other embodiments, the controller 106 can be integrated as a component within the loop driver 104 (not shown here). All such variations are well within the scope of the present application without any limitations whatsoever.

In one or more embodiments, the controller 106 may be connected to the loop driver 104 and each of the loop units using wired and wireless communication protocols known to a person skilled in the art. For instance, in a wired setup, the controller 106 may utilize but is not limited to standard interfaces such as Ethernet and Single Pair Ethernet, UART (Universal Asynchronous Receiver-Transmitter), SPI (Serial Peripheral Interface), or I2C (Inter-Integrated Circuit) to communicate with the loop driver 104 and loop units LU1, LU2.... LUn. Alternatively, in a wireless configuration, protocols like but not limited to Bluetooth, Wi-Fi, or Zigbee could be employed for communication.

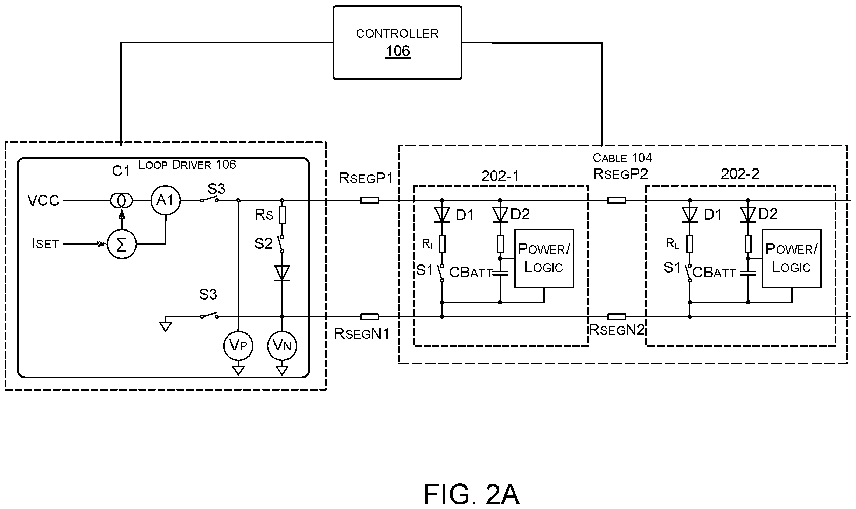

In one or more embodiments, the controller 106 can be configured to selectively activate at least one of the loop units among the plurality of loop units while electrically isolating the remaining loop units among the plurality of loop units LU1, LU2.... LUn. Selectively activating and isolating the loop units can enable targeted diagnostics of individual segments or branches of the loop cable 102. For instance, in a fire alarm system, the controller 106 may activate one loop unit at a time to assess its connectivity and performance, isolating other loop units to avoid interference and false alarm triggering. While activating the loop units, it's important that no other loop units are drawing current. This may be ensured by the loop driver 104 reducing the current flowing through the cable loop, causing a voltage drop. It should be obvious to a person skilled in the art that as the voltage decreases, the respective isolated loop unit draws power from a local source (such as a capacitor) rather than from the cable loop 102 itself. Accordingly, a diode D2 associated with the isolated loop unit may disconnect that loop unit from the cable loop 102 to prevent current flow during the measurement process. For example, as shown in FIG.2A-2C, when the current flowing through the cable 102 is reduced, the voltage decreases, and the diode D2 may be reverse biased and no current may flow into the segment CBatt, and accordingly diode D2 may disconnect the respective loop unit from the loop.

Controller 106, by coordinating the activation of the plurality of loop units LU1, LU2.... Lun and branches $Lu_{B1}...LU_{BN}$, and by monitoring crucial electrical parameters, and analyzing data to determine the resistance of cable's segments and connectors, the controller 106 provides insights into the integrity and performance of the loop cable 102. Through this comprehensive information, operators gain the ability to swiftly identify abnormal resistance values or potential faults occurring within specific segments or branches of the loop cable. Further, the controller 106 may predict the minimum voltages across each segment of the cable 102 and/or across each loop unit during alarm states or normal operating conditions, leveraging the determined resistance values of each of the segments and current that may flow during an alarm state or in normal operating conditions. This functionality can enable to assessment of the electrical integrity and reliability of the cable 102 and the associated alarm system, particularly in critical operational conditions or alarm situations. By analyzing minimum voltage levels, operators gain insights into the overall health and safety of the alarm system, enabling them to identify any areas of concern that may require immediate attention.

Furthermore, the controller 106 can map the determined resistance and minimum voltage data of the cable segments to predefined locations on the cable 102. This mapping capability can allow operators or the controller 106 itself to visually identify the resistance levels and voltage characteristics of different segments of the cable 102. By associating this data with specific locations on the cable 102, operators can pinpoint weak or unsafe segments, facilitating targeted maintenance or replacement efforts to ensure the reliability and safety of the entire cable network. This can allow operators with the information needed to take prompt and targeted corrective actions, thereby mitigating potential risk, and ensuring the continued reliability and safety of the field equipment system.

FIG. 1C illustrates an exemplary representation of the device of FIG. 1A depicted within the context of a dual safety system. For example, redundancy is crucial to ensure continued functionality in the event of malfunctions or hazardous incidents such as fires or explosions. One configuration to achieve this is to provide two different loop drivers 104-1 and 104-2 as shown in FIG. 1C. This configuration mitigates the risk of both parts being affected by a single localized event, thereby enhancing system reliability. For example, in this configuration, the presence of dual loop drivers ensures operational continuity; if one driver becomes compromised due to a fire or explosion or malfunctioning, the other remains unaffected and operational, thus preserving the system's functionality. Further, when the first loop driver 104-1 assumes the task of diagnosing the field equipment loop cable, the corresponding switch S3 within the second loop driver 104-2 is set to the OFF position, while switch S2 is activated to establish a closed loop. Conversely, when the second loop driver 104-2 undertakes the cable diagnosis, switch S3 within the first loop driver 104-1 is deactivated, and switch S2 is activated to maintain loop closure. Thus, the disclosed configuration ensures that each loop driver can independently diagnose the loop cable while maintaining a closed loop for uninterrupted communication. By aligning the states of switches S2 and S3 across the dual loop drivers 104-1 and 104-2, the system facilitates seamless operation and continuous monitoring of the field equipment loop cable, thereby enhancing safety and reliability across various operational scenarios.

In addition to its coordinating function, controller 106 can be configured to detect anomalies or deviations in the cable and associated alarm system from their expected behavior. These anomalies may include sensor failures, communication errors, or other irregularities that may compromise the accuracy of the diagnostic results. Upon detection of such anomalies, the controller 106 may initiate or instruct appropriate corrective actions to address the underlying issues. These actions may involve alerting operators to the presence of errors, logging diagnostic data for further analysis, and/or autonomously initiating diagnostics to ensure the integrity of the diagnostic process. By proactively identifying and addressing potential sources of error, controller 106 can ensure that the diagnostic results remain reliable, allowing operators to make informed decisions and maintain the optimal performance of the alarm system.

In one or more embodiments, the controller 106 may be configured to transmit the determined resistance values and minimum voltages across the cable segments to one or more computing devices (110-1...110-N) associated with one or more operators via a network 108 (as shown in FIG.1B). Transmitting the determined resistance values and minimum voltages allow operators to remotely monitor the health and performance of the cable 102 and associated system. Through this, operators can access detailed information about the resistance levels and voltage characteristics of different segments of the cable 102, facilitating proactive maintenance and troubleshooting efforts to ensure the reliability and safety of the entire cable network.

In one or more embodiments, examples of the network 110 may include, but are not limited to, a Wireless Fidelity (Wi-Fi) network, a Wide Area Network (WAN), a Local Area Network (LAN), or a Metropolitan Area Network (MAN). Various devices in the system 100 can connect to the network in accordance with the various wired and wireless communication protocols such as, but not limited to, Transmission Control Protocol and Internet Protocol (TCP/IP), User Datagram Protocol (UDP), and 2G, 3G, 4G, 5G and 6G communication protocols. In one example, the wireless Fidelity network 730 a cellular network employing a third-generation partnership project (3GPP) release or Institute of Electronics and Electrical Engineers (IEEE) 8020.16p, 802.16n, 802.16m-2011, 802.16h-2010, 802.16j-2009, 802.16-2009. In another embodiment, the communications network may be a Zigbee® connection developed by the ZigBee Alliance such as IEEE 802.15.4-2003 (Zigbee 2003), IEEE 802.15.4-2006 (Zigbee 2006), IEEE 802.15.4-2007 (Zigbee Pro).

**WORKING EXAMPLE:**

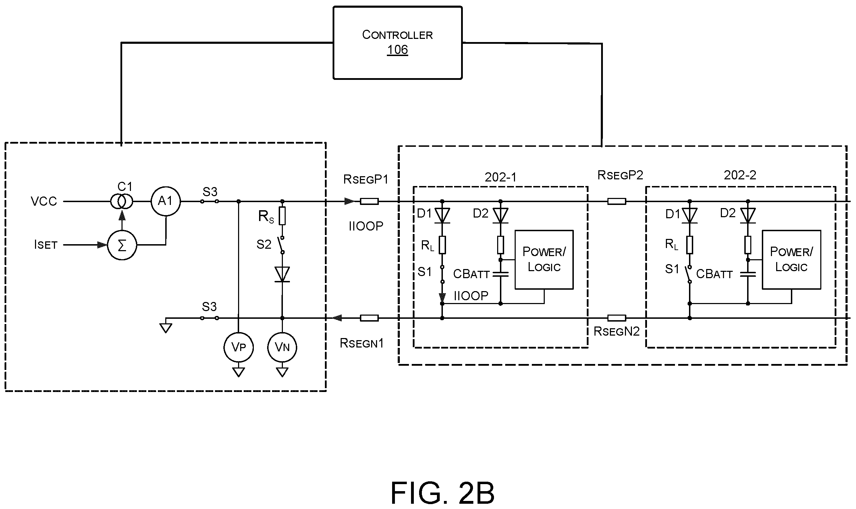

In illustrating the operational dynamics of the invention, consider a scenario involving device 100 for diagnosing a field equipment loop cable 102 connected to two loop units, denoted as 202-1 and 202-2, as illustrated in FIG. 2A. Initially, as shown in FIG. 2B, controller 106 can activate loop unit 202-1 by switching a first switch S1 linked with loop unit 202-1 to an active state, and concurrently isolating (remaining) loop unit 202-2 by deactivating its corresponding first switch S1. This action may prompt the loop driver 104 to detect, via electrical sensors A1, a surge in current within the loop cable 102 upon the shunt resistance's Rs connection to it. Subsequently, upon detecting the surge, the controller 106 can be configured to engage the current limiter C1, thereby regulating the flow of current through the activated loop unit 202-1 to a predetermined level (safe level for the loop unit and cable). Moreover, upon achieving current limitation to the predetermined level, the controller 106 can disengage the second switch, S2, to isolate the shunt resistor Rs from both the loop driver 104 and the cable 102. This isolation can occur during resistance measurement or cable diagnosis. Additionally, the controller 106 can monitor the current flowing through the cable 102 via the activated loop unit 202-1, along with the voltage at both the positive and negative terminals of the cable 102 using the current and voltage sensors (A1, Vp, Vn).

Further, the controller 106 can determine the resistance between the loop driver 104 and the activated loop units 202-1 based on the monitored voltage and current. Activation of loop unit 202-1 establishes an electrical connection between the internal resistance and the cable associated with segment 1. For instance, as illustrated in FIG. 2B, the controller 106 can compute the resistance of a segment 1 (Rcab1 = Rcabp1 + Rcabn1) between the loop driver 104 and the activated loop unit 202-1 using the monitored voltage and current alongside an internal resistance $R_L$ linked with the activated loop unit 202-1.

In one or more embodiments, the actual current can be monitored through a current sensor (A1), while first and second voltage sensors Vn, Vp can monitor the voltage at the cable's positive and negative terminals. The resistance of segment 1 is determined using the formula -

$$(Rcab1) = (Rcabp1 + Rcabn1) = ((Vp - Vd1 - Vn) / Iloop) - RL.$$

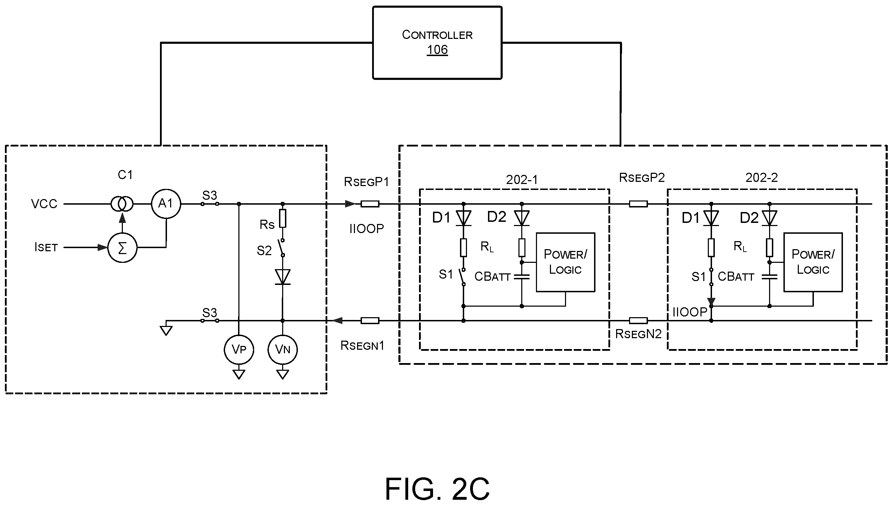

Further, upon ascertaining the resistance of segment 1, the controller 106 can proceed to engage the second switch S2 to electrically connect the shunt resistor Rs in parallel to the cable 102 and the corresponding loop unit 202-1, facilitating the discharge of cable capacitance or residual current. Subsequently, the controller 106 can sequentially activate each loop unit at a time while isolating the remaining units to determine the cable's resistance between the loop driver 104 and each activated loop unit. For instance, as depicted in FIG. 2C, the controller 106 can further activate loop unit 202-2 while isolating loop unit 202-1. Upon activation of loop unit 202-2, a surge in current within the cable 102 can be detected by the loop driver 104, triggering the engagement of current limiter C1 to regulate current flow through the loop cable 102 via the loop unit 202-2 to a predetermined level. Following the current limitation, the controller 106 can disengage the second switch to isolate the shunt resistor Rs from both the loop driver 104 and the cable 102. Further, the controller 106 can determine the resistance of segment 2 (Rcab2) = (Rcabp2 + Rcabn2) between the loop driver 104 and the activated loop unit 202-2 based on the monitored voltage and current and an internal resistance $R_L$ associated with the activated loop unit 202-2. The resistance of the segment two is determined using the formula:

$$(Rcab2) = (Rcabp2 + Rcabn2) = [((Vp - Vd - Vn) / Iloop) - (Rcabp1 + Rcabn1) - Rl]$$

Similarly, to measure the resistance of each of the segments between the remaining loop units as shown in FIG. 1A, the controller 106 can sequentially activate each loop unit at a time while isolating the remaining units and further determine the cable's resistance between the loop driver 104 and the activated loop unit.

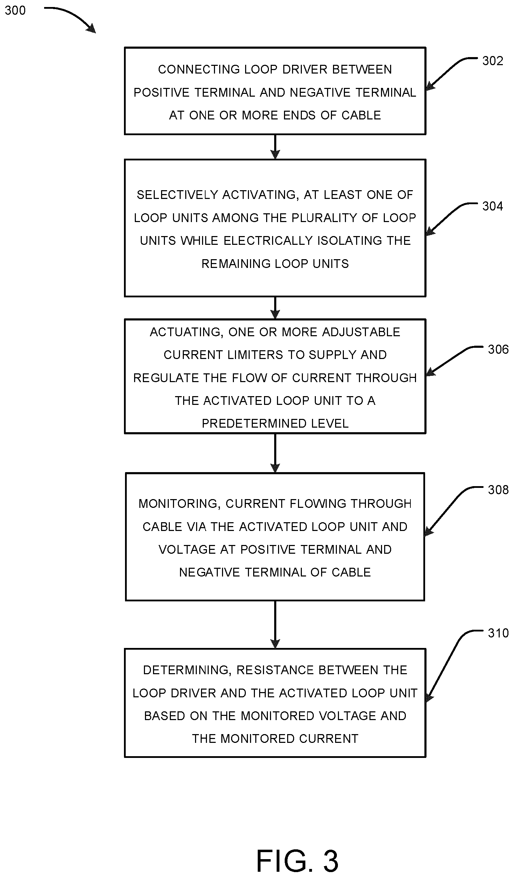

FIG. 3 illustrates a schematic flow diagram for method 300 for diagnosing a field equipment loop cable connected to a plurality of loop units, according to an embodiment of the present disclosure. The method can involve the loop driver, the controller, and other components associated with the loop driver of FIG. 1A, FIG. 1B and 2A-2C.

Referring now to FIG. 3, at step 302, method 300 can include connecting the loop driver between a positive terminal and a negative terminal at one or more ends of the cable. The current limiters of the loop driver can supply and regulate the flow of current through the cable and the respective loop units via the end(s) of the cable. Further, the electrical sensors of the loop driver can monitor the current flowing through the cable and monitor the voltage at the corresponding positive terminal and the negative terminal of the cable.

In one or more embodiments, at step 304, method 300 can include selectively activating at least one of the loop units among the plurality of loop units associated with the cable while electrically isolating the remaining loop units. Further, at step 306, method 300 can include actuating the current limiters to supply and regulate the flow of current through the loop cable to a predetermined level.

Furthermore, at step 308, method 300 can include monitoring the current flowing through the cable via the activated loop unit and the voltage at the positive terminal and the negative terminal of the cable, using one or more electrical sensors. Further, at step 310, method 300 can include determining the resistance between the loop driver and the activated loop unit based on the monitored voltage and the monitored current.

Furthermore, method 300 may include the steps of determining the resistance of a segment of the cable between the loop driver and the activated loop unit, considering the monitored voltage, current, and internal resistance associated with the activated loop unit. Subsequently, method 300 can include sequentially activating each loop unit at a time while isolating the others to determine the resistance of the cable between the loop driver and each activated loop unit. This can facilitate in determining resistance for each segment of the cable and associated branches based on the resistance between the loop driver and each subsequently activated loop unit, as described above.

Furthermore, the method can include the steps of determining minimum voltages across each segment of the cable or each loop unit during alarm states, leveraging the determined resistance values of the segments and current during the alarm state for analysis. Furthermore, the method can include the steps of mapping the determined resistance and minimum voltage data of the cable segments to predefined locations on the cable. This mapping capability allows operators or the controller to visually identify the resistance levels and voltage characteristics of different segments of the cable, aiding in the identification of weak or unsafe segments. By associating this data with specific locations on the cable, operators can pinpoint areas requiring attention, facilitating targeted maintenance efforts, and ensuring the overall reliability and safety of the cable network.

Similarly, the invention may enable systematically determining the resistance of each cable segment and associated branches based on the resistance between the loop driver and each subsequently activated loop unit.

It is to be appreciated by a person skilled in the art that this invention (device and method) provides a solution for the efficient diagnosis and management of loop cable systems within field equipment and alarm system applications. This invention allows operators to identify the resistance of each electrical segment comprising the loop cable system precisely. This insightful data allows for the anticipation of minimum voltages during critical operational conditions, offering operators a proactive approach to system management.

Moreover, the invention enables a granular understanding of the loop cable's behavior, facilitating the precise localization of potential weak points within the cable and associated system. This capability proves invaluable not only during the initial setup of the system but also throughout its operational life. By continuously monitoring resistance variations over time, the invention supports proactive maintenance analysis, alerting operators to potential safety hazards that may arise from issues such as corrosion or poor contact within the loop cable network.

Furthermore, the device's comprehensive diagnostic capabilities extend beyond mere identification to encompass proactive management strategies. Through continuous monitoring and analysis, operators can anticipate and address potential issues before they escalate, thereby ensuring the sustained reliability and safety of the field equipment system. This proactive approach to system management not only enhances operational efficiency but also minimizes downtime and maintenance costs associated with reactive troubleshooting measures.

Thus, this invention provides a solution to accurately measure the resistance of each cable segment and connectors within the field equipment loop connected to multiple units, further allowing precise determination of resistance within branching segments and identification of weak points along the electrical pathway.

While the subject disclosure has been described with reference to exemplary embodiments, it will be understood by those skilled in the art that various changes may be made and equivalents may be substituted for elements thereof without departing from the scope of the subject disclosure as defined by the appended claims. Modifications may be made to adopt a particular situation or material to the teachings of the subject disclosure without departing from the scope thereof. Therefore, it is intended that the subject disclosure not be limited to the particular embodiment disclosed, but that the subject disclosure includes all embodiments falling within the scope of the subject disclosure as defined by the appended claims.

In interpreting the specification, all terms should be interpreted in the broadest possible manner consistent with the context. In particular, the terms "comprises" and "comprising" should be interpreted as referring to elements,

**EP 4 628 906 A1**

components, or steps in a non-exclusive manner, indicating that the referenced elements, components, or steps may be present, or utilized, or combined with other elements, components, or steps that are not expressly referenced. Where the specification claims refer to at least one of something selected from the group consisting of A, B, C ....and N, the text should be interpreted as requiring only one element from the group, not A plus N, or B plus N, etc.

**Claims**

1. A device for diagnosing a field equipment loop cable connected to a plurality of loop units, the device comprising:

   one or more loop driver configured to be connected between a positive terminal and a negative terminal at one or more ends of the cable, wherein the one or more loop driver comprises:

   a current limiter to supply and regulate flow of current through the cable and the respective loop units via the one or more ends of the cable; and
   one or more electrical sensors to monitor the current flowing through the cable and monitor voltage at the corresponding positive terminal and the negative terminal of the cable; and

   a controller connected to the one or more loop driver and each of the loop units, wherein the controller comprises a processor coupled to a memory storing instructions executable by the controller, which causes the controller to:

   selectively activate at least one of the loop units among the plurality of loop units while electrically isolating the remaining loop units among the plurality of loop units;
   actuate the current limiter to supply and regulate flow of the current through the loop cable to a predetermined level;
   monitor, using the one or more electrical sensors, the current flowing through the cable via the activated loop unit and the voltage at the positive terminal and the negative terminal of the cable; and
   determine resistance between the one or more loop driver and the activated loop unit based on the monitored voltage and the monitored current.

2. The device of claim 1, wherein the controller is configured to determine the resistance of a segment, between the one or more loop driver and the activated loop unit, of the cable based on the monitored voltage, the monitored current, and an internal resistance associated with the activated loop unit, wherein the activation of the loop unit electrically connects the internal resistance to the cable.

3. The device of any one of claims 1 and 2, wherein the controller is configured to:

   subsequently activate one of the loop units while electrically isolating the remaining loop units and correspondingly determine the resistance of the cable between the one or more loop driver and each of the subsequently activated loop units; and
   determine the resistance of each of the segments of the cable, and one or more branches associated with the cable based on the determined resistance of the segment between the one or more loop driver and each of the subsequently activated loop units.

4. The device of any one of claims 1 to 3, wherein the controller is connected to one or more first switches associated with each of the loop units, wherein the controller is configured to turn ON the first switch associated with the loop unit to activate the corresponding loop unit, and turn OFF the first switch associated with the loop unit to be electrically isolate the corresponding loop unit from the cable and the one or more loop driver.

5. The device of any one of claims 1 to 4, wherein the one or more electrical sensors comprises:

   a current sensor to monitor the current flowing through the cable via the activated loop unit;
   a first voltage sensor at the positive terminal of the cable to monitor voltage at the positive terminal of the cable; and
   a second voltage sensor at the negative terminal of the cable to monitor voltage at the negative terminal of the cable.

6. The device of any one of claims 1 to 5, wherein the one or more loop driver comprises a shunt resistor of a predefined resistance connected, via a second switch, between a positive wire and a negative wire connecting the one or more loop driver to the positive terminal and the negative terminal of the cable respectively at each of the ends of the cable.

7. The device of claim 6, wherein the controller is configured to actuate the second switch to electrically connect the shunt resistor in parallel to the cable and the corresponding loop unit, which facilitates in discharge of capacitance or residual current of the cable, and
wherein the one or more loop driver is optionally configured to:

   detect, using the electrical sensors, a surge in current within the cable upon the connection of the shunt resistance to the cable; and
   actuate the current limiter to regulate the flow of the current through the loop cable to the predetermined level upon detection of the current surge.

8. The device of claim 6 or 7, wherein the controller is configured to de-actuate the second switch to isolate the shunt resistor from the one or more loop driver and the cable, wherein the shunt resistor is isolated during the resistance measurement or the diagnosis of the cable.

9. The device of any one of claims 1 to 8, wherein the one or more loop driver comprises one or more third switches configured in a positive wire and a negative wire connecting the one or more loop driver to the positive terminal and the negative terminal of the cable respectively at each of the ends of the cable, wherein the controller is connected to each of the third switches and configured to turn ON the third switch to electrically connect the one or more loop driver to the cable, and turn OFF the third switch to electrically isolate the one or more loop driver from the cable and the loop units.

10. The device of any one of claims 1 to 9, wherein the plurality of loop units comprises one or more of a smoke detector, a motion detector, an occupancy detector, an alarm, a beacon module, a control panel, a loop interface modules, input and or output modules, flame detectors, heat detectors, carbon monoxide detectors, gas detectors and a power supply unit, and
wherein the controller is optionally further configured to transmit the determined resistance to a remote monitoring system that is in communication with the one or more loop driver.

11. The device of any one of claims 1 to 10, wherein the controller is further configured to determine minimum voltages across each of the segments of the cable and/or across each of the loop units in an alarm state based on the determined resistance of the one or more segments, and
wherein the controller is optionally configured to map the determined resistance and the determined minimum voltage of the one or more segments to predefined locations on the cable, which enables one or more users or the controller to identify the determined resistance of the one or more segments and/or weak or unsafe segments in the cable.

12. A method for diagnosing a field equipment loop cable connected to a plurality of loop units, the method comprising:

   connecting one or more loop driver between a positive terminal and a negative terminal at one or more ends of the cable;
   selectively activating, by a controller connected to the one or more loop driver and each of the loop units, at least one of the loop units among the plurality of loop units while electrically isolating the remaining loop units among the plurality of loop units;
   actuating, by the controller, current limiter to supply and regulate the flow of current through the loop cable to a predetermined level;
   monitoring, by the controller, the current flowing through the cable via the activated loop unit and the voltage at the positive terminal and the negative terminal of the cable, using the one or more electrical sensors; and
   determining, by the controller, resistance between the one or more loop driver and the activated loop unit based on the monitored voltage and the monitored current.

13. The method of claim 12, further comprising:
determining, by the controller, the resistance of a segment, between the one or more loop driver and the activated loop unit, of the cable based on the monitored voltage, the monitored current, and an internal resistance associated with the activated loop unit, wherein the activation of the loop unit electrically connects the internal resistance to the cable.

14. The method of any one of claims 12 and 13, further comprising:

subsequently activating, by the controller, one of the loop units while electrically isolating the remaining loop units and correspondingly determining the resistance of the cable between the one or more loop driver and each of the subsequently activated loop units; and

determining, by the controller, the resistance of each of the segments of the cable, and one or more branches associated with the cable based on the determined resistance of the segment between the one or more loop driver and each of the subsequently activated loop units, and/or

wherein the one or more loop driver comprises the current limiter configured to supply and regulate the flow of current through the loop cable and the respective loop units via the one or more ends of the cable and one or more electrical sensors to monitor the current flowing through the cable and monitor voltage at the corresponding positive terminal and the negative terminal of the cable.

15. The method of any one of claims 12 to 14, further comprises determining, by the controller, minimum voltages across each of the segments of the cable and/or across each of the loop units in an alarm state based on the determined resistance of the one or more segments,

the method optionally further comprising mapping, by the controller, the determined resistance, and the determined minimum voltage of the one or more segments to predefined locations on the cable, which enables one or more users or the controller to identify the determined resistance of the one or more segments and/or weak or unsafe segments in the cable.

FIG. 1A

EP 4 628 906 A1

**FIG. 1B**

FIG. 1C

EP 4 628 906 A1

FIG. 2A

FIG. 2B

FIG. 2C

300

CONNECTING LOOP DRIVER BETWEEN
POSITIVE TERMINAL AND NEGATIVE TERMINAL
AT ONE OR MORE ENDS OF CABLE

302

SELECTIVELY ACTIVATING, AT LEAST ONE OF
LOOP UNITS AMONG THE PLURALITY OF LOOP
UNITS WHILE ELECTRICALLY ISOLATING THE
REMAINING LOOP UNITS

304

ACTUATING, ONE OR MORE ADJUSTABLE
CURRENT LIMITERS TO SUPPLY AND
REGULATE THE FLOW OF CURRENT THROUGH
THE ACTIVATED LOOP UNIT TO A
PREDETERMINED LEVEL

306

MONITORING, CURRENT FLOWING THROUGH
CABLE VIA THE ACTIVATED LOOP UNIT AND
VOLTAGE AT POSITIVE TERMINAL AND
NEGATIVE TERMINAL OF CABLE

308

DETERMINING, RESISTANCE BETWEEN THE
LOOP DRIVER AND THE ACTIVATED LOOP UNIT
BASED ON THE MONITORED VOLTAGE AND
THE MONITORED CURRENT

310

FIG. 3

**EUROPEAN SEARCH REPORT**

Europäisches
Patentamt
European
Patent Office
Office européen
des brevets

Application Number

EP 25 16 4225

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 236 217 B1 (LEWIS ANDREW BIGGERSTAFF [GB] ET AL) 22 May 2001 (2001-05-22) | 1-5,10, 12-14 | INV. G01R27/08 |
| A | * the whole document * | 6-9,11, 15 | G01R27/16 G01R31/58 |
| | ----- | | G01R31/66 |
| A | EP 3 357 203 B1 (ROSEMOUNT INC [US]) 4 March 2020 (2020-03-04) * claims 1,2 * | 1-15 | |
| | ----- | | |
| A | US 2011/010120 A1 (WEHRS DAVID L [US] ET AL) 13 January 2011 (2011-01-13) * claims 1,3 * | 1-15 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 8 August 2025 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 4225

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2025

| Patent document cited in search report | | Publication date | Patent family member(s) | | Publication date |
|---|---|---|---|---|---|
| US 6236217 | B1 | 22-05-2001 | CN | 1228161 A | 08-09-1999 |
| | | | DE | 69726580 T2 | 16-09-2004 |
| | | | EP | 0920636 A1 | 09-06-1999 |
| | | | US | 6236217 B1 | 22-05-2001 |
| | | | WO | 9808104 A1 | 26-02-1998 |
| EP 3357203 | B1 | 04-03-2020 | CN | 106556416 A | 05-04-2017 |
| | | | CN | 113124909 A | 16-07-2021 |
| | | | CN | 205719015 U | 23-11-2016 |
| | | | EP | 3357203 A1 | 08-08-2018 |
| | | | JP | 6543417 B2 | 10-07-2019 |
| | | | JP | 2018531456 A | 25-10-2018 |
| | | | US | 2017093533 A1 | 30-03-2017 |
| | | | WO | 2017058527 A1 | 06-04-2017 |
| US 2011010120 | A1 | 13-01-2011 | CN | 102959363 A | 06-03-2013 |
| | | | EP | 2452163 A2 | 16-05-2012 |
| | | | JP | 5548266 B2 | 16-07-2014 |
| | | | JP | 2012533121 A | 20-12-2012 |
| | | | RU | 2490596 C1 | 20-08-2013 |
| | | | US | 2011010120 A1 | 13-01-2011 |
| | | | WO | 2011005938 A2 | 13-01-2011 |

EPO FORM P0459

For more details about this annex : see Official Journal of the European Patent Office, No. 12/82